# EUROPEAN PATENT APPLICATION

(11) **EP 2 833 109 A1**
(43) Date of publication of application: **04.02.2015**
(21) Application number: 13178822.6
(22) Date of filing: 31.07.2013
(51) Int. Cl.: G01L 1/12, G01L 3/10, G01L 25/00, H01L 41/12

(54) **Measurement apparatus with compensation**

(71) Applicant: Bayern Engineering GmbH & Co. KG, 83043 Bad Aibling (DE)
(72) Inventor: May, Lutz Axel, 82335 Berg, Starnberger See (DE)
(74) Representative: Huebner, Stefan Rolf

(57) **Abstract**

The invention relates to a measurement apparatus (1) for detecting an amount of mechanical stress on a test object (12), the measurement apparatus (1) being adapted to generate a magnetic field and to receive the magnetic field to detect a change of a magnetic property of the test object (12) due to the mechanical stress exerted on the test object (12). The measurement apparatus (1) is furthermore adapted to compensate for changes of one or more additional physical properties of the test object (12) the change of the magnetic property of which is detected and/or adapted to compensate for changes of one or more environmental properties affecting the test object (12).

Thus, the invention allows providing a measurement apparatus (1) for measuring mechanical stress through detecting a change of a magnetic property of the test object (12), the measurement apparatus allowing adjustment of the measurement scale in view of one or more additional physical properties of the test object (12) and/or one or more environmental properties.

## Description

### Field of the invention

The invention relates to a measurement apparatus according to the preamble of claim 1.

### Background of the invention

From the laid open document EP 2 397 830 A2 a torque and force measurement system is known for measuring torque and/or force impact on a corpus. The corpus may, for example, be a bicycle drive shaft or a wind turbine shaft. A field generator arrangement, which comprises a coil wound around a ferromagnetic flux concentrator, applies a magnetic field to the corpus. The coil may be powered by a DC or an AC signal, for example with a frequency between 200 Hz and 1000 Hz. The corpus modifies the morphological structure due to the torque and/or force impact so as to influence the generated field. This modification can be determined by a magnetic field sensor arrangement, which may likewise comprise a coil and a flux concentrator.

Laid open document DE 197 45 781 A1 discloses a measurement apparatus adapted to correct an output value of the measurement apparatus. The measurement apparatus may be used to measure the stress caused by a load on a truck or a similar vehicle. The measurement apparatus can compensate for changes in the environmental temperature and for changes due to aging effects of the material of the measurement apparatus.

In patent application CN 101 368 842 A, a track dynamic weighing method is disclosed. It features a weighing method using two weighing points, which have equal distance from two fulcrums on a weight track. The sensor which adopts a three-pole E-shaped integral iron core measures the force borne by the track exploiting the counter magnetostrictive effect in an amorphous alloy thin film layer attached to the measurement points on the central axis of the lateral side of the rail. This thin layer of amorphous alloy is located between the detector iron core and the rail itself.

WO 02/063254 A1 teaches a weight sensor and a weighing method for the static and dynamic weighing of vehicles or the wheel and axle loads thereof. The weight sensor comprises a main processor which can be connected to sensor units like temperature sensors to improve the accuracy of the weight measurement.

### Problem to be solved by the invention

It is an object of the present invention to improve the measurement apparatus according to the preamble of claim 1. For instance, a measurement apparatus shall be improved with respect to its accuracy and/or versatility.

### Solution according to the invention

According to the invention, the problem is solved by a measurement apparatus according to the preamble of claim 1, wherein the measurement apparatus is furthermore adapted to compensate for changes of one or more additional physical properties of the test object the change of the magnetic property of which is detected and/or adapted to compensate for changes of one or more environmental properties affecting the test object.

Stress in the sense of the present invention is a physical quantity that expresses the internal forces that neighboring particles of a continuous material exert on each other. Stress on a test object may be increased by exerting a mechanical load, for example by putting a weight, on a test object. Stress may also be increased by accelerating a test object, for example, by rotating the test object at high revolutions, so that a torque creates a mechanical load and thus increases the stress on the test object.

A test object in the sense of the present invention is preferably ferromagnetic, though in some embodiments the test object may be anti-ferromagnetic. This means that it preferably comprises a ferromagnetic substance or material. In some embodiments, the test object comprises an anti-ferromagnetic substance or material in addition or in the alternative. A test object in the sense of the present invention is a carrier element carrying a mechanical load, the mechanical load causing a stress on the carrier element. Such carrier element may for example be a rail of a railroad track or a chassis of a vehicle, such as a wheeled vehicle or of a train engine or of a plane. Another test object in the sense of the invention is an axle which may be rotating or fixed so that torque or any other stress causes a force on the axle, thus changing the magnetic property of the ferromagnetic axle. Such axles are found as driving shafts in wind wheels or water wheels, for example.

In a preferred measurement apparatus the majority, i.e. more than 50%, of the magnetic property change as registered by the measurement apparatus, stems from a change of the magnetic property of the test object itself. Preferably, more than 70%, more preferably more than 80%, more preferably more than 99%, more preferably the entire property change as registered by the measurement apparatus stems from a change of a magnetic property of the test object. In the present invention, one may think of the test object as part of the measurement apparatus, preferably as part of a flux concentrator.

The advantage of having a measurement apparatus that is adapted to compensate for changes of one or more additional physical properties of the test object the change of the magnetic property of which is detected and/or adapted to compensate for changes of one or more environmental properties affecting the test object may be that even if such properties change, a reliable and accurate measurement of the change of the magnetic property remains possible. Furthermore, the same measurement apparatus may be used serially on different types of test objects having different physical properties and/or being situated in different environmental settings while still being able to retrieve reliable measurement information as a recalibration of the measurement scale is possible.

### Preferred embodiments of the invention

It is preferred that a physical effect underlying the change of the magnetic property to be detected by the measurement apparatus is the inverse magnetostrictive effect. The inverse magnetostrictive effect allows the stress on a test object to be calculated based on the change of the magnetic susceptibility of the test object due to stress on that test object caused by the stress. For example, the test object may be a rail of a railroad track, the rail carrying a train as the stress. The test object may comprise a ferromagnetic and/or an antiferromagnetic material. Preferably, the test object consists of ferromagnetic steel as such test objects are known for exhibiting the inverse magnetostrictive effect to an extent that allows proper measurement of the change of the magnetic property.

In a preferred embodiment, the measurement apparatus is adapted to compensate for the change of one or more of the additional physical properties of the test object the change of the magnetic property of which is detected, the additional physical property being selected from the group comprising temperature of the test object, alloy composition of the test object, surface hardness of the test object, surface structure of the test object, mass of the test object and change of the permanent magnetisation. These physical properties may affect the measurement process in addition to the effect caused by a weight load or a torque, which herein are considered merely special causes for mechanical stress, and thus, may affect the accuracy of the magnetic property detection. Especially when the measurement apparatus shall be interchanged between two different test objects having for example different masses or different alloy compositions, the measurement apparatus needs to be re-calibrated to allow a reliable measurement result. If the measurement apparatus is adapted to compensate for such property changes, the calibration process may be enhanced. In some applications the bending behavior and thus the change of the magnetic property may change, for example when the temperature of the test object changes or when the measurement apparatus is interchanged between different test objects having different surface structures and/or masses and/or diameters and/or surface hardnesses. This may affect the scaling dependency between stress and detected change of the magnetic property. Thus, if, for example, the effect of temperature on a bending behavior of a certain test object is known in advance from standardized tests, either absolutely or relatively, it becomes possible to deduct information about the temperature of the test object in the field from the change of the magnetic property detected by receiving the generated magnetic field directed through the test object. This may provide an important prerequisite for compensating the aforementioned factors.

It is preferred that the measurement apparatus is adapted to compensate for the change of one or more of the environmental properties affecting the magnetic field to be received from the group comprising presence of ferromagnetic objects near the test object or presence of magnetic stray fields. A magnetic stray field may for example be generated by the measurement apparatus itself or by magnetic objects other than the test object but close to the test object. A magnetic stray field may originate from various sources. For example, the measurement apparatus may comprise one or more permanent magnets for mounting the measurement apparatus to the test object. Such permanent magnet may emit a magnetic stray field affecting the measurement in addition to the effect caused by the stress on the test object. A magnetic stray field may also occur as a loss from the magnetic field generated to detect the change of the magnetic property of the test object. Usually, the larger the test object is, with respect to the mass of the test object, the higher the magnetic stray field ratio in comparison to the total strength of the emitted magnetic field will be. Thus, by having the measurement apparatus being adapted for compensating for such effects, the scaling of the measurement apparatus for detecting the change of the magnetic effect may be adjusted, so that the measurement result is only or almost only based on the mechanical stress affecting the test object.

It is preferred that the measurement apparatus is adapted to compensate for the change of at least one of the physical properties and/or the environmental properties through comparisons of signal profiles of the received magnetic field. A signal profile in the sense of the present invention is an electric signal curve generated by the measurement apparatus on the basis of the received magnetic field and reflecting the relationship between the stress on the test object and the received magnetic field, thus allowing to draw conclusions about the load borne by the test object or a torque. As changing physical properties and/or environmental properties will additionally influence the signal profile, the signal profile allows furthermore to gain information about present physical and/or environmental conditions when comparing a newly measured signal profile to pre-stored or simulated signal profiles reflecting known physical and/or environmental conditions. The signal profile of the magnetic field is characterized by properties of the signal generated by the received magnetic field, such as signal amplitude, signal gain, signal offset and signal hysteresis. By analyzing one, some or all of those signal profile features, for example by comparing actual signal profiles of received magnetic fields to expected signal profiles of magnetic fields, such as one or more simulated or pre-stored magnetic fields, the effect of the changing additional property on the detected change of the magnetic property may be determined and suitable measures for compensating errors may be taken.

In a preferred embodiment, the measurement apparatus comprises one or more generator coils for generating a magnetic field and one or more feedback coils for receiving the magnetic field generated by the generator coil. The coils form a sensing module of the measurement apparatus. Preferably, the measurement apparatus comprises exactly one generator coil and/or exactly one feedback coil. In some embodiments though, two, three or more generator coils and/or two, three or more feedback coils are present. In a preferred embodiment, the measurement apparatus comprises exactly one generator coil and two feedback coils. It is preferred that the generator coil and at least one feedback coil are wound around a common pole shoe acting as a flux concentrator. In a preferred embodiment, the pole shoe has the cross section of the letter U. A feedback sensor may be mounted in the space between the two open legs of a U-shaped pole shoe. In a preferred embodiment this feedback sensor is also a coil. In other embodiments, this feedback sensor may be a Hall effect sensor, a magneto-resistant sensor, a giant magneto-resistant sensor, and the like. An embodiment of such a sensor design is known from EP 2397830 A2. That sensor design having a generator coil wound around a U-shaped pole shoe and having a feedback sensor positioned between the open legs of the U-shaped pole shoe, is hereby incorporated by reference in the present description.

It is preferred that the measurement apparatus comprises sensor electronics having an electric generator drive circuit for powering the one or more generator coils. In a preferred embodiment, the electric generator drive circuit powers the generator coil with a constant level of current (DC). In other embodiments, the generator coil is powered with a one-time increasing or decreasing current. In yet other embodiments, amplitude modulated current of one polarity, amplitude modulated current of positive and negative polarity (AC), currents with controlled fixed frequency or currents with controlled changing frequencies are supplied to the generator coil for generating the magnetic field.

In a preferred embodiment, the sensor electronics comprise at least one digital component. A digital component is an integrated semiconductor circuit which provides logic, memory or microprocessing functionality. It is preferred that the sensor electronics comprise a microprocessor for processing and/or manipulating measurement data. This may greatly enhance the versatility of the measurement apparatus. It is preferred that the sensor electronics comprises analogue components in addition or in alternative to digital components. Such analogue electronics components are, for example, resistors, coils and capacitors. Analogue components are well known and easy to obtain. Preferably, an analogue component is located in the circuit connecting the generator coil to the sensor electronics. For example, in an embodiment a resistor may replace a wire segment of the wire connection connecting sensor electronics to the sensing module so that a current or voltage applied to that wire may be measured. Preferably, the resistor is located in the circuit connecting the generator coil to the sensor electronics. In some embodiments, an analogue component is located in the circuit connecting a feedback coil to the sensor electronics. Thus, voltage and/or current measurements may be performed in the circuit connecting a feedback coil to the sensor electronics in such embodiments.

In a preferred embodiment, the sensor electronics comprise storage means for storing information, the information allowing computation of physical properties of the test object, the computation being based on the received magnetic field. Preferred storage means are semiconductor memory chips. The memory may be either of a non-volatile or a volatile memory type. Thus, measurement data may be stored temporarily or permanently in the sensor electronics. In preferred embodiments, a microprocessor may perform calculations on the stored data. In the alternative, analogue components may be used for storing the information.

It is preferred that the sensor electronics comprise computation means adapted to compare a signal profile of a received magnetic field to one or more profiles of pre-programmed magnetic fields stored in the storage means. In a preferred embodiment the pre-programmed signal profiles are stored in storage means. A preferred computation means is a microprocessor. Thus, the signal profile of a received magnetic field may be compared to the signal profiles in the storage means by the computation means to determine compensation information to compensate for unwanted effects of changing additional physical properties or environmental effects on the received magnetic field. In the alternative, the signal profile of the received magnetic field may be compared to a simulated signal profile, preferably calculated by the computation means. For example, a theoretical signal profile may be calculated by the computation means, preferably on the basis of an inputted mass and/or alloy composition of a standard test object. In preferred embodiments, deviations between the simulated signal profile and the signal profile of the received magnetic field may be used to draw conclusions about the actual physical properties of the test object in order to compensate for unwanted effects of additional physical properties and/or environmental properties on the stress measurement.

In a preferred embodiment, the sensor electronics comprise adjustment means to provide an adjustment of the generator drive circuit and/or the feedback coil. In a preferred embodiment, the adjustment means adjust electric settings of the generator drive circuit. Thus, preferably, the sensor electronics comprise adjustment means for controlling the generator drive circuit for powering the generator coil. Thereby the current of the generator coil may be increased or decreased depending on the magnetic measurement signal. In other embodiments, the signal provided by the feedback coils is adjusted. Thus, for example the signal gain and/or the signal offset of the signal of one or more feedback coils may be increased or decreased to compensate for physical or environmental effects on the test object. An amplifier component is preferably part of the sensor electronics and adapted to increase the signal gain of one or more of the feedback coils. Other adjustment means can be provided in addition or in the alternative by providing a microprocessor adapted to control voltage and/or current adjustments on elements of the measurement apparatus. The microprocessor may be adapted to control the signal gain and/or the signal offset of the feedback coils. Preferably, the microprocessor is adapted to adjust multiple or all of the necessary settings as described above to compensate for distorting effects caused by physical or environmental properties of the test object.

In a preferred embodiment, the sensor electronics are adapted to provide the adjustment of the generator drive circuit and/or one or more of the feedback coils in real time. Thus, recalibration of the measurement apparatus can be accelerated and improved, which may render such an embodiment of a measurement apparatus more user-friendly. In a preferred embodiment, only the settings of the generator coil driver or the settings of the feedback coils are real-time corrected. In other embodiments both, the settings of the generator coil driver and the settings of the feedback coils, are provided with a real-time correction.

It is preferred that the sensor electronics are adapted to provide the adjustment of the generator drive circuit and/or the feedback coil automatically and/or by user interaction. An automatic adjustment may improve the user-friendliness of such a measurement apparatus. Allowing user interaction for example via input means, such input means being for example one or more buttons or turn knobs, a keyfield, a keyboard or a touchscreen, may allow manual control of the correction parameters so that automatic adjustments become unnecessary, which may allow to reduce the number of expensive electronic calculation components such as microprocessors. Furthermore, in some embodiments the automatic adjustments may be overridden manually via input means, such input means being for example one or more buttons or turn knobs, a keyfield, a keyboard or a touchscreen, so that the user may influence the rescaling process. In some embodiments visualization means are provided on the measurement apparatus, preferably to visualize the received magnetic field and options for compensation. Preferably, the sensor electronics comprises a signal output so that measurement and/or compensation information may be transferred to external computing devices. In that case, preferably input means and visualization means at the measurement apparatus may be omitted.

It is preferred that the measurement apparatus is adapted to compensate for the effect of the mass of the test object on the received magnetic field by measuring a power consumption of one or more of the generator coils. When the physical mass of the test object is very low, only little energy is required to run the generator coil of the measurement apparatus. Using too much electric power will generate an unnecessarily strong magnetic field, resulting in a negative effect on the measurement accuracy. On the other hand, if the mass of the test object is high, the generator coil requires a higher level of electric power to generate a magnetic field strong enough to provide a sufficient signal amplitude. In this case, a large portion of the magnetic field generated is wasted in the surrounding metal mass of the test object. Thus, the mass of the test object may be determined by measuring the power consumption of one or more of the generator coils.

In a preferred embodiment, the measurement apparatus is adapted to compensate for the effect of the temperature of the test object on the received magnetic field by measuring the electrical resistance of one or more of the generator coils. In a preferred embodiment, one or more generator coils are formed from a segment of copper wire. When the electrical resistance of the generator coil increases, the voltage at the generator coil will change, as long the driver current is kept constant. Thus, the strength of the magnetic field generated by the generator current remains constant, independently of the operating temperature of the generator coil. That is why the electric current generated in the feedback coil remains therefore unchanged. That means, when the power consumption of the generator coil is changing, but an output signal of the feedback coil does not change it is a strong indication that the temperature of the test object changes. This will lead to a significantly different signal profile in comparison to the case in which the test object mass is changing, allowing to distinguish a temperature change of the test object from a change of mass. Instead of a copper wire, in some embodiments of the invention a wire comprising platinum or other conductive metals may be employed for measuring the electrical resistance.

### Brief description of the drawings

The invention is illustrated in greater detail with the aid of schematic drawings.
- Figure 1:: Figure 1 shows a first embodiment of a flux concentrator and coil arrangement for an embodiment of the invention;
- Figure 2:: Figure 2 shows a second embodiment of a flux concentrator and coil arrangement for an embodiment of the present invention;
- Figure 3:: Figure 3 shows a schematic wiring diagram of an embodiment of a measurement apparatus;
- Figure 4:: Figure 4 shows an illustration of a stray field and a field induced into a test object by a measurement apparatus according to the present invention;
- Figure 5:: Figure 5, divided into the subfigures a) and b), shows schematic drawings of measurement apparatuses measuring the change of the magnetic property of two test objects with different masses; and
- Figure 6:: Figure 6 shows another schematic wiring diagram of a measurement apparatus according to the present invention.

### Detailed description of embodiments of the inventions

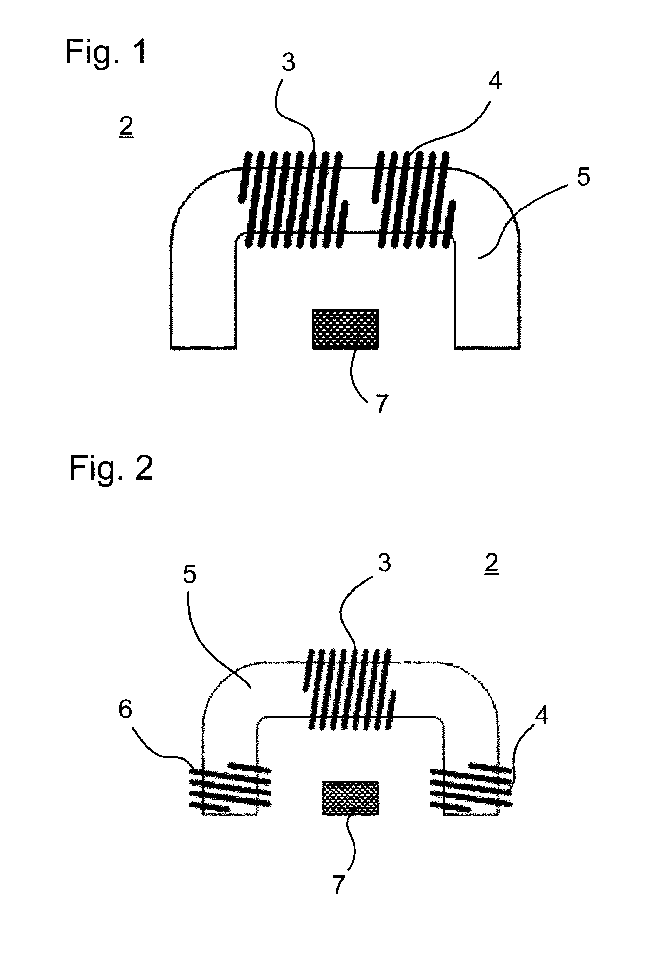

Figures 1 to 6 show embodiments of measurement apparatuses 1 according to the invention or elements which can be of importance for such measurement apparatuses 1.

Figures 1 and 2 show two different embodiments of sensing modules 2. The sensing modules 2 may be part of a measurement apparatus 1 according to the present invention. In

Figure 1, the sensing module 2 comprises a generator coil 3 and a first feedback coil 4 each wound around a flux concentrator 5 which has the purpose to concentrate a magnetic field.

In this case, the flux concentrator 5 is used as a common pole shoe for the generator coil 3 and the first feedback coil 4. The flux concentrator 5 has the general shape of the letter U.

The generator coil 3 and the first feedback coil 4 are arranged at the part of the flux concentrator 5 connecting the two arms of the U-shape and are thus arranged in a collinear configuration.

Figure 2 shows a second embodiment of a sensing module 2 in which a second feedback coil 6 is present. In this embodiment, the generator coil 3 is as well wound around the part of the flux concentrator 5 connecting the two arms of the U-shape while the first feedback coil 4 and the second feedback coil 6 are each wound around one of the arms of the U-shaped flux concentrator 5. Thus, the generator coil 3 is arranged in a perpendicular orientation with regards to the first feedback coil 4 and the second feedback coil 6 in this embodiment and in respect to the axes of the feedback coils 4, 6. In both depicted embodiments, a third feedback coil 7 is arranged between the two arms of the U-shaped flux concentrator 5. In another embodiment (not shown) the third feedback coil 7 is replaced by a Hall effect sensor. All three feedback coils 4, 6, 7 mentioned above are formed from segments of copper wire.

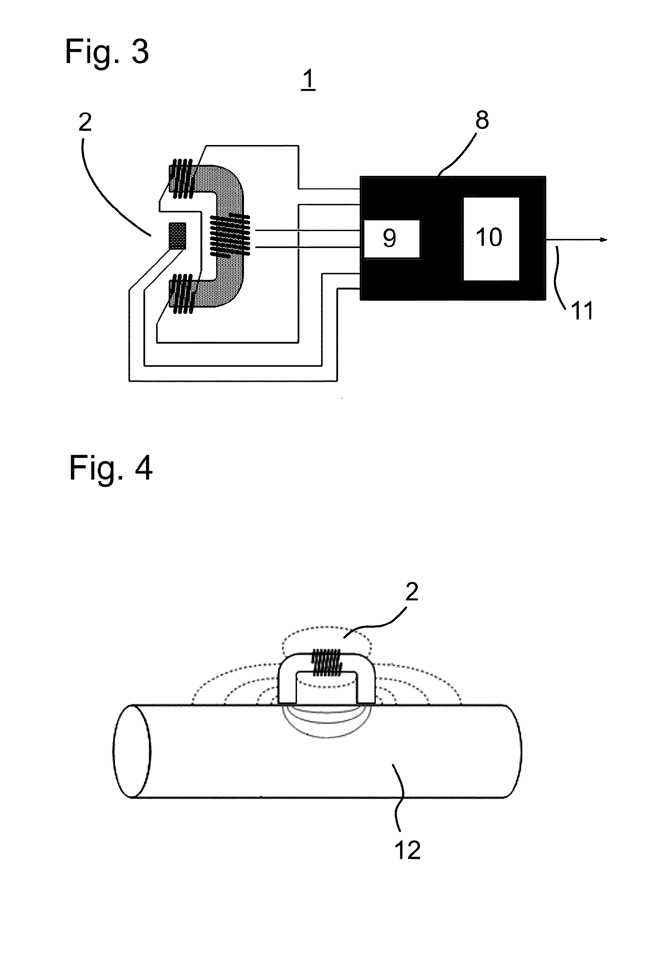

Figure 3 shows a schematic wiring diagram of an embodiment of sensor electronics 8 being connected to the sensing module 2. A sensing module 2 as shown in Fig. 2 is used. The sensor electronics 8 comprise multiple digital components. A generator drive circuit 9 is adapted to power the generator coil 3 of the sensor. The generator drive circuit 9 supplies a regulated single supply voltage to the generator coil 3. In the present embodiment, it provides DC current to the generator coil 3. Furthermore a digital controller 10 is part of the sensor electronics 8. The digital controller 10 is a microprocessor and is adapted to perform feedback signal processing and measurement signal conditioning on a signal received from the three feedback coils 4, 6, 7, the signal being provided when a magnetic field generated by the generator coil 3 is received by the feedback coils 4, 6, 7. Thus, the digital controller 10 serves as an adjustment means. The sensor electronics 8 are powered by an electric current (not shown). To power the generator coil 3 and to receive the signal from the feedback coils 4, 6, 7, the sensor electronics 8 are connected to the sensing module 2 via wires. Typically there are six wires connecting the sensing module 2 to the sensor electronics 8. In the depicted embodiment, two wires connect the generator coil 3 to the generator drive circuit 9. The first feedback coil 4 and the second feedback coil 6 are connected in a serial connection. Thus, one wire connects the first feedback coil 4 to the sensor electronics 8, one wire connects the first feedback coil 4 to the second feedback coil 6 and one wire connects the second feedback coil 6 to the sensor electronics 8, the connection being established for feedback signal processing within the sensor electronics 8. Furthermore, two wires connect the third feedback coil 7 to the digital controller 10 for measurement signal conditioning. After signal processing in the digital controller 10, the processed signal can be obtained from a sensor signal output 11 which is present at the sensor electronics 8.

The described measurement apparatus 1 comprising the sensing module 2 and the sensor electronics 8 is capable of detecting an amount of mechanical stress on a test object 12 by generating a magnetic field via the generator coil 3 and by receiving the magnetic field via the feedback coils 4, 6, 7 to detect a change of a magnetic property of the test object 12 caused by the mechanical stress exerted on the test object 12. Figures 4, 5 and 6 depict how such a measurement may be performed. More detailed information on such a measurement may be obtained from EP 2 397 830 A which is incorporated herein by reference with respect to how the measurement process is conducted.

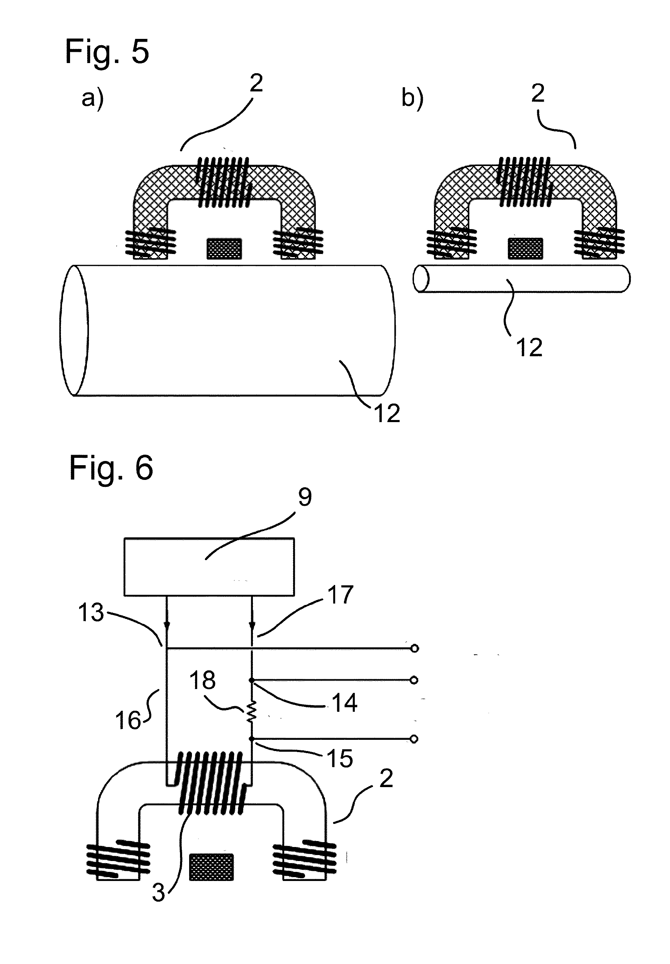

In the example shown in figure 5, for the sake of clarity in line with the following explanation, only the generator coil 3 is depicted on the sensing module 2. A test object 12, in this case a ferromagnetic pipe, carries a mechanical load (not shown) which increases a stress in the test object 12. This affects the magnetic properties of the test object 12. The physical effect underlying the change of the magnetic property to be detected by the measurement apparatus is the inverse magnetostrictive effect. By measuring the intensity of that effect, the amount of load, thus the weight, borne by the test object 12, can be determined. This measurement may be performed by inducing a magnetic field into the test object 12 by driving the generator coil 3 with a voltage provided by the generator drive circuit 9. The sensing module is put to the test object 12 with the ends of the two arms of the flux concentrator 5 facing the surface of the test object 12. Powered by the generator drive circuit 9, the generator coil 2 then emits a magnetic field and the feedback coils 4, 6, 7 receive that magnetic field and emit a signal via the wires so that the sensor electronics 8 may detect the change of the magnetic property of the test object 12, the magnetic field being altered ideally due to the change of the magnetic property of the test object 12 only. The field strength necessary for performing such a measurement depends for example on the temperature, the mass or the alloy composition of the test object 12. With increasing field strength, not only the magnetic field passing through the test object 12 increases in strength, but also unwanted magnetic stray fields may increase. Those magnetic stray fields and also other environmental or physical properties may affect the detection outcome in addition to the effect caused by the change of the magnetic property, thus distorting the result of the load detection.

To overcome this problem, the measurement apparatus is furthermore adapted to compensate for changes of one or more additional physical properties of the test object 12 the change of the magnetic property of which is detected and/or adapted to compensate for changes of one or more environmental properties affecting the test object 12. Examples for such physical properties are the temperature of the test object 12, the alloy composition of the test object 12, the surface hardness of the test object 12, the surface structure of the test object 12 and the mass of the test object 12. Examples for such environmental properties are the presence of ferromagnetic objects near the test object 12 or the presence of magnetic stray fields.

The measurement apparatus 1 is adapted to detect the change of at least one of the additional physical properties and/or the environmental properties through comparison of profiles of the received magnetic field. The electric signal provided by the third feedback coil 7 after receiving the magnetic field is directly related to the mechanical load applied to the test object 12 while the electric signals provided by the first feedback coil 4 and/or a second feedback coil 6 are used to optimize the settings of the measurement apparatus 1. The digital controller 10 of the sensor electronics 8 in this embodiment is a semiconductor microprocessor. It identifies and characterizes the signal profiles collected via the feedback coils 4, 6, 7. By using lookup tables and/or algorithms and utilizing adjustment means (not shown), for applying sensor adjustments based on the profile of the received magnetic field the digital controller 10 can change the settings of the generator drive circuit 9. This means the digital controller 10 is adapted to control the output of the generator drive circuit 9. Furthermore, in this embodiment the digital controller 10 can apply adjustments to the third feedback coil 7 signal amplitude and/or signal offset to correct the measurement results via an amplifier component (not shown). Thus, to store such lookup tables, the sensor electronics 8 comprise storage means, in this embodiment a semiconductor memory chip (not shown), for storing information, the information allowing the computation of the additional physical properties of the test objects 12 in addition to the measured magnetic property, the computation being based on the received magnetic field. The digital controller 10 serves as a computation means adapted to compare the signal profile of the received magnetic field to one or more signal profiles of pre-programmed magnetic fields stored in the storage means. In a further step, adjustment means included in the sensor electronics 2 apply the aforementioned adjustments based on the received magnetic field, as described above. In the described embodiment, an adjustment of the generator drive circuit 9 and the feedback coil by the digital controller 10 occurs in real-time and automatically. In other embodiments, means for manually overriding and/or manually adjusting the automatic adjustment are present.

Being adapted to perform signal comparison, the measurement apparatus 1 is adapted to compensate for the effect of the mass of the test object 12 on the received magnetic field by measuring the power consumption of one or more of the generator coils 3. The mass of the test object 12 may in some situations be relatively large in comparison to the mass of the generator coil 3 (Figure 5a) or the mass of the test object 12 may in other situations be relatively small in comparison to the generator coil 3 (Figure 5b). When the mass of the generator coil 3 is similar to the mass of the test object 12 or even larger than the mass of the test object 12, the DC current, as used in the given embodiments, or an AC high frequency current in other embodiments, applied to power the generator coil 3 is relatively low. In an embodiment where a low frequency AC is used for powering the generator coil 3, a comparably low mass of the test object 12, in comparison to the mass of the generator coil 3, will lead to a relatively high power consumption of the generator coil 3. Furthermore, when the mass of the test object 12 is small, the signal amplitude provided by the first feedback coil 4 and/or the second feedback coil 6 is low and vice versa. A third aspect is, that, when the mass of the test object 12 is small in comparison to the mass of the generator coil 3, the signal amplitude provided by the third feedback coil 7 is higher than when the mass of the test object 12 is comparably large. The signal amplitude then may even be saturated. Thus, it becomes possible to store a number of such signal profiles for test objects having known masses in the measurement apparatus and compare those pre-stored signal profiles automatically to actual measurement data via the digital controller 10 to determine the mass of the test object 12. Furthermore, if an inappropriately high current or signal amplitude is detected, the digital controller 10 may adjust the generator drive circuit 9 settings or feedback coil 4, 6, 7 settings accordingly to allow an improved measurement.

In a second aspect, the shown embodiments of the invention are adapted to detect the change of the hardness of the surface of the test object 12 and the diameter of the test object 12. The digital controller 10 is adapted to analyze the signal gain and the signal hysteresis of the feedback coils 4, 6, 7. From this information it becomes possible to draw conclusions about the hardness of the surface and also the diameter of the test object 12. The harder the surface of the test object 12 is and/or the larger the diameter of the test object 12 is, the lower the bending effect of the mechanical load on the test object 12 will be. Thus, the change of the magnetic property will be smaller, resulting in a lower signal amplitude and lower signal gain of the signal provided by the feedback coils 4, 6, 7 after receiving the magnetic field. By using pre-stored magnetic signal profiles from a lookup table or using a simulated signal generated by arithmetics in the digital controller 10, conclusions about the surface hardness and/or diameter of the test object 12 may be drawn and a correction of the signal amplitude and/or signal gain may be performed by the sensor electronics.

The measurement apparatus 1 is furthermore enabled to detect the temperature of the test object 12. This allows compensating for temperature changes and its effect on the stress measurement. Again, no additional elements need to be added to the measurement apparatus 1 for this analysis as only a measurement of currents and voltages in the sensor electronics circuit is necessary. An embodiment adapted for temperature measurement is shown in Figure 6. For measuring voltages in the sensor electronics 2, a first, a second and a third measurement point 13, 14, 15 are defined. The first measurement point 13 is located on a first wire 16 of the two wires connecting the generator drive circuit 9 to the generator coil 3. The second measurement point 14 and the third measurement point 15 are located at the second wire 17 of the two wires connecting the generator drive circuit 9 to the generator coil 3. Between the second measurement point 14 and the third measurement point 15, a section of the second wire 17 is replaced by a resistor 18. In this embodiment, the resistor 18 has the resistance of 1 Ohm. Over the first measurement point 13 and the second measurement point 14, the generator driver voltage U₁ can be determined, while between the second measurement point 14 and the third measurement point 15 the voltage drop U₂ at the resistor 18 can be measured. Thus, the generator drive current can be calculated from Ohm's law by using the formula I = U₂/ R. To determine a temperature change of the test object 12, the generator drive current is kept constant. With a rise in the temperature of the generator coil 3 the resistance of the generator coil 3 will increase as well. As the current is kept constant, the voltage at the generator coil 3 will change accordingly. The magnetic field generated by the generator coil 3 will remain constant though as the current is kept constant. Because of that the signal generated in the first feedback coil 4 and the second feedback coil 6 and the signal generated by the third feedback coil 7 will remain unchanged. This signature can be detected by the digital controller 10 and will be identified as a temperature change in the test object 12, as, for example, a change of mass of the test object 12 will result in a different signal profile. The sensor electronics 8 are adapted to perform the voltage and current measurements. In this embodiment, specifically the digital controller 10 comprises means for measuring voltage and current.

In conclusion, the present invention allows providing a measurement apparatus 1 for detecting a mechanical stress on a test object 12 by measuring changes of a magnetic property of the test object 12, the measurement apparatus 1 allowing to compensate for properties of the test object 12 or its environment. By having sensor electronics 8 adapted to measure voltages and currents in the measurement apparatus 1 and for performing signal comparison, the measurement apparatus 1 may allow to, for example, adapting signal gain of the feedback coils 4, 6, 7 or strength of the magnetic field emitted by the generator coil 3 in accordance with the physical properties of the test object 12, thus allowing a more accurate load or torque measurement. Advantageously, such measurement apparatuses 1 may be used as mobile sensors for use on different ferromagnetic test objects 12 and/or as weight sensors on railroad tracks. For this purpose, the measurement apparatus may comprise permanent magnets for connecting the measurement apparatus 1 removably to the test object 12. The magnetic stray fields of said permanent magnets and their effects on the measurements may be compensated by the sensor electronics 8, for example by signal comparison as described above.

The features described in the above description, claims and figures can be relevant to the invention in any combination. Their reference numerals in the claims have merely been introduced to facilitate reading of the claims. They are by no means meant to be limiting.

### List of reference numerals

- 1: Measurement apparatus
- 2: Sensing module
- 3: Generator coil
- 4: First feedback coil
- 5: Flux concentrator
- 6: Second feedback coil
- 7: Third feedback coil
- 8: Sensor electronics
- 9: Generator drive circuit
- 10: Digital controller
- 11: Signal output
- 12: Test object
- 13: First measurement point
- 14: Second measurement point
- 15: Third measurement point
- 16: First wire
- 17: Second wire
- 18: Resistor

## Claims

1. A measurement apparatus (1) for detecting an amount of mechanical stress on a test object (12), the measurement apparatus (1) being adapted to generate a magnetic field and to receive the magnetic field to detect a change of a magnetic property of the test object (12) due to the mechanical stress exerted on the test object (12),
**characterized in that**
the measurement apparatus (1) is furthermore adapted to compensate
• for changes of one or more additional physical properties of the test object (12) the change of the magnetic property of which is detected and/or
• for changes of one or more environmental properties affecting the test object (12).

2. The measurement apparatus (1) according to claim 1
**characterized in that**
the physical effect underlying the change of the magnetic property to be detected by the measurement apparatus (1) is the inverse magnetostrictive effect.

3. The measurement apparatus (1) according to claim 1 or 2,
**characterized in that**
the measurement apparatus (1) is adapted to compensate for the change of one or more of the additional physical properties of the test object (12) the change of the magnetic property of which is detected, the additional physical property being selected from the group comprising temperature of the test object (12), alloy composition of the test object (12), surface hardness of the test object (12), surface structure of the test object (12), mass of the test object (12) and a permanent magnetization of the test object (12).

4. The measurement apparatus (1) according to any of the preceding claims,
**characterized in that**
the measurement apparatus (1) is adapted to compensate for the change of one or more of the environmental properties affecting the magnetic field to be received from the group comprising presence of ferromagnetic objects near the test object (12) or presence of magnetic stray fields.

5. The measurement apparatus (1) according to any of the preceding claims,
**characterized in that**
the measurement apparatus (1) is adapted to detect the change of at least one of the additional physical properties and/or the environmental properties through comparison of signal profiles of the received magnetic field.

6. The measurement apparatus (1) according to any of the preceding claims,
**characterized in that**
the measurement apparatus (1) comprises one or more generator coils (3) for generating a magnetic field and one or more feedback coils (4, 6, 7) for receiving the magnetic field generated by the generator coil (3).

7. The measurement apparatus (1) according to any of the preceding claims,
**characterized in that**
the measurement apparatus (1) comprises sensor electronics (8) having an electric generator drive circuit (9) for powering the one or more generator coils (3).

8. The measurement apparatus (1) according to claim 7,
**characterized in that**
the sensor electronics (8) comprise at least one digital component.

9. The measurement apparatus (1) according to any of the claims 7 or 8,
**characterized in that**
the sensor electronics (8) comprise storage means for storing information, the information allowing computation of the additional physical properties of the test object (12), the computation being based on the received magnetic field.

10. The measurement apparatus (1) according to claim 9,
**characterized in that**
the sensor electronics (8) comprise computation means adapted to compare a signal profile of a received magnetic field to one or more signal profiles of pre-programmed magnetic fields stored in the storage means.

11. The measurement apparatus (1) according to any of the claims 7 to 10,
**characterized in that**
the sensor electronics (8) comprise adjustment means to provide an adjustment of the of the generator drive circuit (9) and/or the feedback coil (4, 6, 7).

12. The measurement apparatus (1) according to any of the claims 7 to 11,
**characterized in that**
the sensor electronics (8) are adapted to provide the adjustment of the generator drive circuit (9) and/or the feedback coil (4, 6, 7) in real-time.

13. The measurement apparatus (1) according to the claims 11 or 12,
**characterized in that**
the sensor electronics (8) are adapted to provide the adjustment of the generator drive circuit (9) and/or the feedback coil (4, 6, 7) automatically and/or by user interaction.

14. The measurement apparatus (1) according to any of the preceding claims,
**characterized in that**
the measurement apparatus (1) is adapted to compensate for the effect of the mass of the test object (12) on the received magnetic field by measuring the power consumption of one or more of the generator coils (3).

15. The measurement apparatus (1) according to any of the preceding claims,
**characterized in that**
the measurement apparatus (1) is adapted to compensate for the effect of the temperature of the test object (12) on the received magnetic field by measuring the electrical resistance of one or more of the generator coils (3).
